# EUROPEAN PATENT SPECIFICATION

(11) **EP 2 653 318 B1**
(45) Date of publication and mention of the grant of the patent: **18.11.2015**
(21) Application number: 13159044.0
(22) Date of filing: 13.03.2013
(51) Int. Cl.: B44C 3/02, B44C 5/04, B44F 9/00, B44F 9/02

(54) **Method for manufacturing a case frame and an electronic device employing said case frame**
Verfahren zur Herstellung von einem Gehäuserahmen und eine elektronische Vorrichtung, die diesen verwendet
Procédé de fabrication d'un cadre de boîtier et dispositif électronique l'utilisant

(30) Priority: 02.04.2012 KR 20120033882
(43) Date of publication of application: 23.10.2013
(73) Proprietor: Samsung Electronics Co., Ltd, Gyeonggi-do 443-742 (KR)
(72) Inventor: Hwang, Chang-Youn, Gyeonggi-do (KR); Ahn, Seng-Ho, Gyeongsangbuk-do (KR); Lee, Pil-Woo, Gyeongsangbuk-do (KR)
(74) Representative: Gover, Richard Paul

(56) References cited:
- US-A- 3 467 538
- US-A- 3 561 103
- US-A1- 2010 098 920
- US-A1- 2010 279 043
- US-B2- 6 713 691

## Description

### BACKGROUND OF THE INVENTION

### 1. Field of the Invention

The present invention relates to a method for manufacturing a case frame for a housing in various electronic devices and an electronic device employing thereof.

### 2. Description of the Related Art

Recently, the development of electronic devices is being applied to various fields closely related to modem life. More particularly, among such electronic devices, a portable terminal is often considered a most indispensable apparatus in our lives. Particularly, among the portable terminals, a mobile communication terminal with a main purpose of voice and/or video communication has developed rapidly. Since a processing speed of this portable terminal has continued to rapidly improve and a smart phone reinforcing various additional functions such as web surfing, etc. has become a mainstream device, it is no exaggeration to say that each person carries at least one terminal.

Since these electronic devices are brought to the market in various sizes according to a function thereof and a user's demand or preference, attention is paid to external elegance as well as the function and slimness of the device. Therefore, even when possessing the generally the same function as an apparatus of a different company, an apparatus having a more excellent and elegant design is preferred by a user.

More particularly, a case frame forming an appearance of an apparatus should be generally excellent in all aspects of design and touch and texture, when a user grips the apparatus, the feel should be also excellent. Contrary to an electronic technology developing rapidly, apparatuses having a nature-friendly design, touch, and texture are preferred over the apparatuses which do not possess such qualities.

Therefore, the carrying case of the electronic device is developing from a case frame manufactured by a painting process using a single color (black, white, red, green, etc.) to a process that uses a real (actual) material such as wood, stone, rubber, etc.

However, when a case frame is manufactured using these real materials, the durability quickly deteriorates, and high costs is consumed compared to a case frame manufactured by injecting the conventional synthesis resin, and consequently, manufacturing costs of a product is raised and an adverse effect is given to sales volume.

Therefore, recently, a pattern such as rubber, wood, etc. is formed on an injection object formed of a synthetic resin or metal and the injection object is painted with a similar color, so that a user may have texture similar to that of a real material such as rubber, wood, etc. However, since this method has a limitation in realizing an elegant and delicate texture of a material and passes through a single painting process, weather resistance and corrosion resistance deteriorate, so that quality of a product quickly deteriorates due to low degree of completion.

Examples of such techniques are described in US patent documents US 3,467,538 and US 3,561,103. In each case, a textured pattern is formed on a workpiece and one or more painted layer is applied to the textured surface of the workpiece.

In particular, US 3,561,103 discloses a method for manufacturing a case frame comprising the steps of (i) forming a case frame with a tactile texture in a shape corresponding to an applied product, (ii) forming a paint layer having a color corresponding to the relevant material that is to be simulated, (iii) forming a pattern layer corresponding to a visual texture pattern that simulates a visual texture of the relevant material, and (iv) forming a transparent layer.

### SUMMARY OF THE INVENTION

An aspect of the present invention is to address at least some of the above-mentioned problems and/or disadvantages and to provide at least some of the advantages described below. Accordingly, an aspect of the present invention is to provide a method for manufacturing a case frame that provides the same touch and texture as those of a real material. In other words, the present invention

simulates the texture (e.g. feel) of a plurality of real materials including but not limited to naturally formed materials such as wood, rubber, etc. In addition, the texture of man-made materials can also be simulated (some non-limiting examples being synthetic rubber, alloys, etc.).

In this aspect of the present invention, the case both visually and texturewise simulates another material.

Another exemplary aspect of the present invention is to provide a method for manufacturing a case frame that realizes excellent competitiveness in manufacturing costs by providing a high quality case frame while reducing manufacturing costs.

Still another exemplary aspect of the present invention is to provide a method for manufacturing a case frame that provides the same texture as that of a real material by only adding a simple process to the manufacture of the case, thereby providing high quality satisfaction to consumers.

In accordance with the present invention, a method for manufacturing a case frame according to claim 1 is provided.

Furthermore, the forming of the case frame includes injecting a preform formed of a synthetic resin so that it is suitable for a shape using a mold, wherein an injection surface of the mold is processed to correspond to a texture pattern of the relevant material and the injection surface is formed by at least one time of an etching process using a predetermined film on which the texture pattern of the material is formed.

Other exemplary aspects, advantages and salient features of the invention will become more apparent to those skilled in the art from the following detailed description, which, taken in conjunction with the annexed drawings, discloses exemplary embodiments of the invention.

### BRIEF DESCRIPTION OF THE DRAWINGS

The above and other exemplary aspects, features and advantages of certain exemplary embodiments of the present invention will become more apparent to a person of ordinary skill in the art from the following description taken in conjunction with the accompanying drawings in which:
FIGS. 1 and 2 are a front perspective view and a rear perspective view, respectively, illustrating an electronic device to which a case frame manufactured by a method according to an exemplary embodiment of the present invention has been applied;
FIG. 3 is a flowchart illustrating exemplary operation of a process for manufacturing a case frame according to an exemplary embodiment of the present invention;
FIG. 4 is a cross-sectional view illustrating a case frame manufactured by a method according to an exemplary embodiment of the present invention;
FIG. 5 is a view illustrating a film for etching and a mold for case frame injection according to an exemplary embodiment of the present invention; and
FIG. 6 is a photo illustrating a case frame produced by a manufacturing method according to an exemplary embodiment of the present invention.

Throughout the drawings, like reference numerals will be understood to refer to like parts, components and structures.

### DETAILED DESCRIPTION

The following description with reference to the accompanying drawings is provided to assist a person of ordinary skill in the art with a comprehensive understanding of exemplary embodiments of the invention as defined by the appended claims. It includes various specific details to assist in that understanding but these are to be regarded as merely exemplary. Accordingly, those of ordinary skill in the art will recognize that various changes and modifications of the exemplary embodiments described herein can be made without departing from the scope of the invention. as defined by the appended claims Also, descriptions of well-known functions and constructions may be omitted for clarity and conciseness when their inclusion would obscure appreciation of the present invention by an artisan with such well-known functions and constructions.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention are provided for illustration purposes only and not for the purpose of limiting the invention as defined by the appended claims. The appended claims are not limited to the examples shown and discussed herein.

In describing the present invention, a mobile terminal is illustrated as an electronic device, and a method for manufacturing a case frame of the mobile terminal is described. However, the present invention is not limited thereto but is applicable to case frames of various apparatuses and is applicable to various fields such as an inner interior of an automobile (for example, a dashboard, a center fascia, etc.) even though it is not an electronic device.

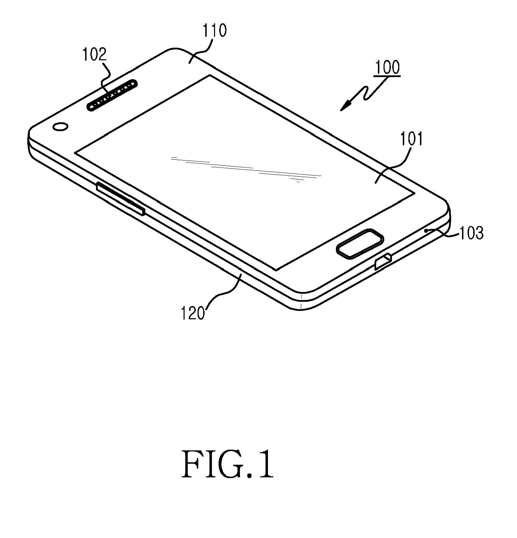

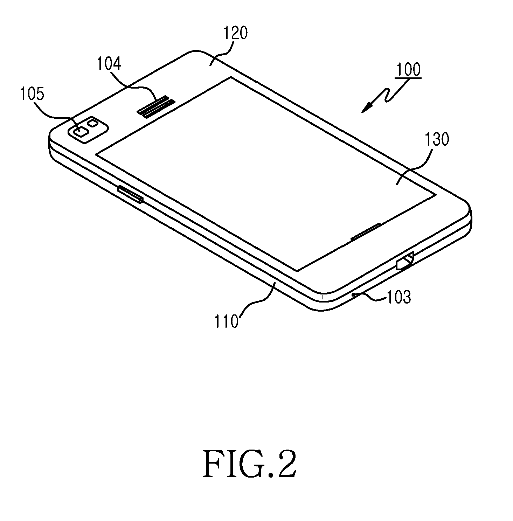

FIGS. 1 and 2 are a front perspective view and a rear perspective view, respectively, illustrating an electronic device to which a case frame manufactured by a method according to an exemplary embodiment of the present invention has been applied.

As illustrated in FIGS. 1 and 2, a mobile terminal 100 includes an upper case frame 110 coupled with a lower case frame 120 to form an enclosed appearance of the mobile terminal with certain openings for ports, plugs, display of the touchscreen, buttons or switches, etc. At this point, a plurality of electronic function groups including a substrate may be mounted in an inner space formed by the upper case frame 110 and the lower case frame 120.

A display unit 101 is installed in the upper case frame 110 so that at least one surface is exposed from the case, an ear-piece 102 for communication is installed in the upper portion of the display unit 101, and a microphone 103 for communication is installed in the lower portion of the display unit 101.

Also, after a battery pack is received inside the mobile terminal 100, a battery cover 130 (shown in FIG. 2) for finally covering the battery pack may be detachably installed in the lower case frame 120, and a camera lens assembly 105 and a speaker unit 104 may be further installed. In the event the electronic device is a mobile terminal, the device would typically include a controller configured for operation, a wireless transceiver that includes a wireless transmitter and wireless receiver in wireless protocols that may include, just to name a few non-limiting possibilities, one or more of WiFi, Wimax, WiBro, RF, visual light communication (VLC), Bluetooth, 802.11, CDMA, GSM, LTE, and other wireless protocols According to the present invention, when portions of the case that expose peripheral devices of the mobile terminal 100 such as the display unit 101, the ear-piece 102, the microphone 103, the camera lens assembly 105, etc. are excluded, the appearance of the upper and lower case frames 110 and 120 may be realized using a manufacturing method according to the present invention. Therefore, since texture of a real material can be simulated even without using a real material, an elegant appearance can be achieved both visually and with regard to texture.

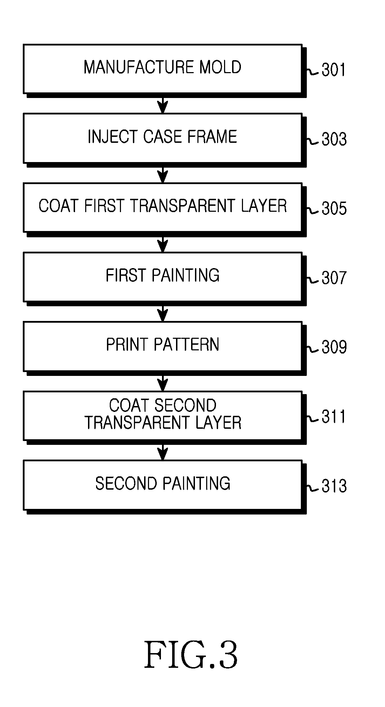

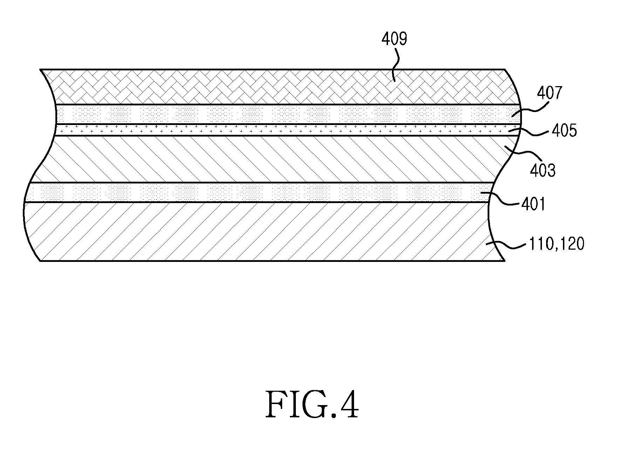

FIG. 3 is a flowchart illustrating exemplary operation of a process for manufacturing a case frame according to an exemplary embodiment of the present invention, and FIG. 4 is a crucial cross-sectional view illustrating a case frame manufactured by a method according to an exemplary embodiment of the present invention.

Referring now to FIGS. 3 and 4, a process for manufacturing a mold for forming case frames 110 and 120 is performed in step 301. Preferably, an injection surface for injecting outer surfaces of the case frames 110 and 120 is manufactured via etching a plurality of times. For example, a film having a shape corresponding to the texture of a relevant real material to be simulated is manufactured, and an injection surface of a mold is etched a plurality of times using this film, so that various patterns of that simulate a real material are formed in the surface. An etching process of at least two or more times of may be performed to form a pattern simulating a wood grain shape in the injection surface of the mold.

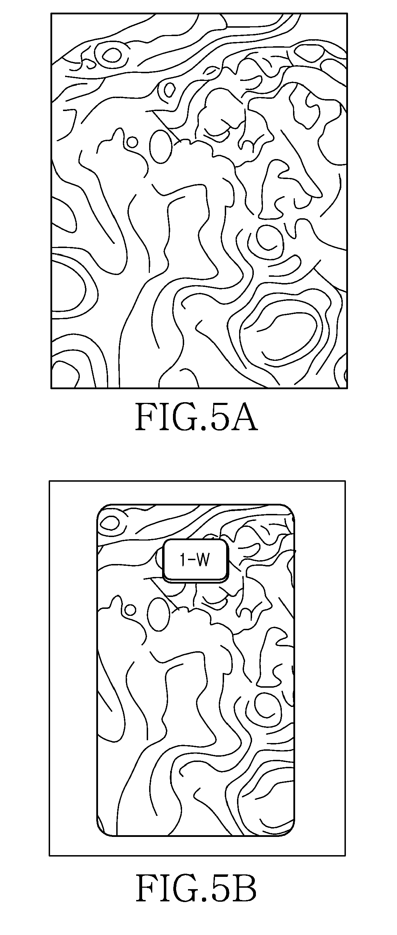

FIG. 5 is a view illustrating a film for etching and a mold for case frame injection according to an exemplary embodiment of the present invention, FIG. 5A illustrates a shape of this film, and FIG. 5B illustrates a state where a pattern of a simulated material is formed in the injection surface of the mold via an etching process using this film.

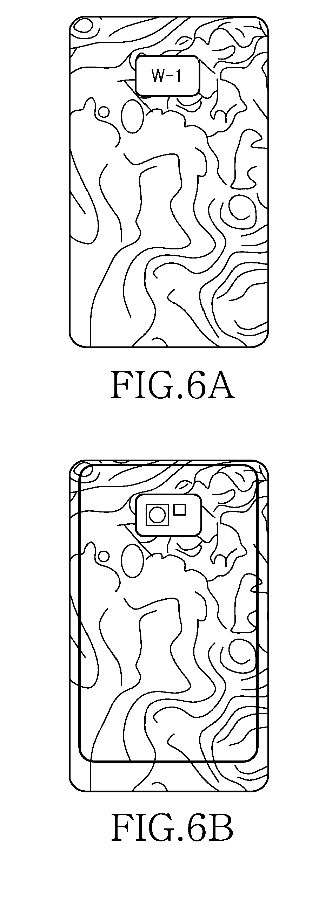

Next at step 303, a process for injecting the case frames 110 and 120 using the mold in which the pattern of the simulated material is formed is performed. At this point of the process, the case frames 110 and 120 may be formed of a synthetic resin. Therefore, the case frames 110 and 120 are injected with the same pattern formed in its both sides by the mold in which the pattern of the simulated material is formed. FIG. 6A illustrates a photo of a case frame injected by the above-described pattern mold.

Subsequently, at step 305 a process for coating the injection surfaces of the case frames 110 and 120 with a first transparent layer 401 is performed. The first transparent layer 401 may be formed by spraying and painting a SiO₂-based solvent such as a glass component or acrylic urethane. Also, the first transparent layer 401 may be formed to have a thickness of about 10-20 µ m via a transparent urethane paint.

After that, the first transparent layer 401 is dried via a process of an oven or a natural dry, etc., and then at step 307 a first painting process for forming a basic color paint layer 403 by painting basic color corresponding to a particular simulated material is performed.

At step 309, a pattern printing process for printing a pattern on the upper portion of the basic color paint layer 403 is performed. For example, the pattern printing process is for printing a shadow corresponding to the pattern of the simulated material. At this point, a printing operation may be performed on a relevant portion of the pattern of the basic color paint layer periodically or non-periodically or repeatedly. For this printing process, a Digital Dot Print (DDP) and a laser transfer method may be used, but are not the only way to operate this process. Therefore, more abundant texture of the simulated material may be expressed via a pattern print layer 405 formed in this manner. A total thickness of the basic color paint layer 403 and the pattern print layer 405 may be in the range of about, for a non-limiting example, 20-150 µ m.

Then at step 311, a process for coating an upper portion of the basic color paint layer 403 and the pattern print layer 405 with a second transparent layer 407 is performed. This second transparent layer 407 may protect the basic color paint layer 403 and the pattern print layer 405 from the outside even when a second paint layer 409, which will be described later, is damaged. The second transparent layer 407 may be also used via a method of spraying transparent urethane paint having a predetermined gloss. A thickness of this second transparent layer 407 may be in the range of about, for a non-limiting example, 10-30 µm.

At step 313 a process for forming the second paint layer 409 is performed. The second paint layer 409 allows color of the basic color paint layer and the pattern print layer to be expressed naturally and allows a user to feel smooth texture of the simulated material that corresponds to texture of a real material like rubber or wood grains by a coating of Soft Feel (SF) paint.

The SF paint is urethane paint characterized by soft touch of leather and an appearance of leather and has an advantage that weather resistance, solvent resistance, chemical resistance, and abrasion resistance are excellent, in fact far superior to actual leather. The SF paint is classified into SF-based paint characterized by smooth touch and appearance, SF-HJ based paint used for an exclusive product for attach-difficult material, and SF-5 based paint maximizing a sense (texture and appearance) of rubber, and SF-6 based paint maximizing a sense of slip. Therefore, relevant SF paint corresponding to a pattern characteristic of an applied relevant real material is preferably used. Preferably, a thickness of the second paint layer 409 by the SF paint may be in the range of about, for a non-limiting example, 10-45 µ m.

FIG. 6B is an illustration of a case frame finally completed by a manufacturing process according to the present invention. Texture and an appearance that simulate a real material are formed

Though not shown, the first paint layer 403 and the pattern print layer 405 according to the present invention are applicable to not only an injection object by a mold of a synthetic resin but also to case frames formed of metal such as stainless, aluminum, magnesium, etc. formed by construction methods such as pressing, die casting, etc. For example, the simulated leather can be arranged on a stainless case according to the process described herein above.

A method for manufacturing a case frame according to the present invention additionally forms a pattern print layer suitable for a texture pattern that simulates a real material after performing a basic color paint process on an injected case frame, so that more excellent pattern texture can be provided to a user and consequently, product reliability can improve.

Although the invention has been shown and described with reference to certain exemplary embodiments thereof, it will be understood by those skilled in the art that various changes in form and details may be made therein without departing from the scope of the invention as defined by the appended claims. Therefore, the scope of the present invention should not be limited to the above-described exemplary embodiments but should be determined by the appended claims

## Claims

1. A method for manufacturing a case frame (110, 120), the method comprising:
forming a case frame (110, 120) with a tactile texture in a shape corresponding to an applied product;
forming a first transparent layer (401) by coating a surface of the formed case frame (110, 120) to a predetermined thickness;
forming a first paint layer (403) on a surface of the coated case frame (110, 120) having a color corresponding to a relevant material that is to be simulated;
forming a pattern print layer (405) on an upper portion of the first paint layer (403) corresponding to a visual texture pattern that simulates a visual texture of the relevant material;
forming a second transparent layer (407) by coating an upper portion of the first paint layer (403) and the pattern print layer (405) to a predetermined thickness;
forming a second paint layer (409) on a coated upper portion of the first paint layer (403) and the pattern print layer (405); and
forming the second paint layer (409) such that the color of the first paint layer (403) and the visual texture pattern of the pattern print layer (405) are externally visible, thereby providing the user with a visual and tactile texture of the simulated material that corresponds to a visual and tactile texture of the relevant material.

2. The method of claim 1, wherein the forming of the case frame comprises injecting a pre-form formed of a synthetic resin to provide a shape using a mold,
wherein an injection surface of the mold is processed so that the simulated material corresponds to the tactile texture pattern of the relevant material and the injection surface is formed by at least one time of an etching process using a predetermined film on which the tactile texture pattern of the simulated material is formed.

3. The method of claim 1, wherein the first transparent layer (401) is formed by spraying transparent urethane paint on the case frame (110, 120).

4. The method of claim 3, wherein the predetermined thickness of the first transparent layer (401) is in a range of 10-20 µm.

5. The method of claim 1, wherein a total thickness of the first paint layer (403) and the pattern print layer (401) is formed in a range of 20-150 µm.

6. The method of claim 1, wherein the pattern print layer (405) is formed using at least one of a Digital Dot Print, DDP, and a laser transfer method.

7. The method of claim 1, wherein the second transparent layer (407) is formed by spraying transparent urethane paint.

8. The method of claim 7, wherein the predetermined thickness of the second transparent layer (407) is in a range of 10-30 µm.

9. The method of claim 1, wherein the second paint layer (409) is formed as a coating of Soft Feel (SF)-based urethane paint, said SF-based paint being a urethane paint having the texture and appearance of leather.

10. The method of claim 1, wherein the case frame is formed of metal using at least one of pressing and die casting.

11. The method of claim 10, wherein the case frame comprises at least one of stainless, aluminum, magnesium, and copper.

12. The method of claim 1, wherein the case frame is applied for a housing employed for a portable terminal which is an electronic device.

13. The method of claim 1, wherein the relevant material simulated in texture comprises at least one of wood and rubber.

14. The method of claim 1, wherein the case frame is manufactured for an electronic device, wherein the electronic device for which the case frame is manufactured comprises a mobile terminal and comprises a window for a touch screen.

15. An electronic device having a housing, the housing comprising:
a case frame (110, 120) formed to have a tactile texture in a shape corresponding to the electronic device; a first transparent layer (401) formed on a surface of the case frame (110, 120) to a predetermined thickness;
a first paint layer (403) formed on a surface of the case frame (110, 120) and having a color corresponding to a relevant material that is to be simulated;
a pattern print layer (405) formed on an upper portion of the first paint layer (403) and corresponding to a visual texture pattern that simulates a visual texture of the relevant material;
a second transparent layer (407) formed on an upper portion of the first paint layer (403) and the pattern print layer (405) to a predetermined thickness; and
a second paint layer (409) formed on an upper portion of the second transparent layer (407); and
wherein the second paint layer (409) is formed such that the color of the first paint layer (403) and the visual texture pattern of the pattern print layer (405) are externally visible, thereby providing the user with a visual and tactile texture of the simulated material that corresponds to a visual and tactile texture of the relevant material..

## Patentansprüche

1. Verfahren zur Herstellung von einem Gehäuserahmen (110, 120), wobei das Verfahren umfasst:
Bilden eines Gehäuserahmens (110, 120) mit einer taktilen Textur zu einer Form, die einem angewandten Produkt entspricht;
Bilden einer ersten transparenten Schicht (401) durch Beschichten einer Oberfläche des gebildeten Gehäuserahmens (110, 120) zu einer vorbestimmten Dicke;
Bilden einer ersten Farbschicht (403) auf einer Oberfläche des beschichteten Gehäuserahmens (110, 120) mit einer Farbe, die einem relevanten zu simulierenden Material entspricht;
Bilden einer Musterdruckschicht (405) auf einem oberen Abschnitt der ersten Farbschicht (403), die einem visuellen Texturmuster entspricht, das eine visuelle Textur des relevanten Materials simuliert;
Bilden einer zweiten transparenten Schicht (407) durch Beschichten eines oberen Abschnitts der ersten Farbschicht (403) und der Musterdruckschicht (405) zu einer vorbestimmten Dicke;
Bilden einer zweiten Farbschicht (409) auf einem beschichteten oberen Abschnitt der ersten Farbschicht (403) und der Musterdruckschicht (405); und
Bilden einer zweiten Farbschicht (409) derart, dass die Farbe der ersten Farbschicht (403) und des visuellen Texturmusters der Musterdruckschicht (405) äußerlich sichtbar sind, dabei wird dem Benutzer eine visuelle und taktile Textur des simulierten Materials bereitgestellt, die einer visuellen und taktilen Textur des relevanten Materials entspricht.

2. Verfahren nach Anspruch 1, wobei das Bilden des Gehäuserahmens das Einspritzen in eine Vorform umfasst, die aus einem Kunstharz gebildet ist, um eine Form unter Verwendung einer Gießform bereitzustellen,
wobei eine Einspritzoberfläche der Gießform so verarbeitet ist, dass das simulierte Material dem taktilen Texturmuster des relevanten Materials entspricht und die Einspritzoberfläche durch wenigstens einmal eines Ätzprozesses unter Verwendung eines vorbestimmten Films gebildet wird, auf dem das taktile Texturmuster des simulierten Materials gebildet ist.

3. Verfahren nach Anspruch 1, wobei die erste transparente Schicht (401) durch Sprühen transparenter Urethanfarbe auf den Gehäuserahmen (110, 120) gebildet wird.

4. Verfahren nach Anspruch 3, wobei die vorbestimmte Dicke der ersten transparenten Schicht (401) im Bereich von 10-20 µm liegt.

5. Verfahren nach Anspruch 1, wobei die gesamte Dicke der ersten Farbschicht (403) und der Musterdruckschicht (401) im Bereich von 20-150 µm gebildet wird.

6. Verfahren nach Anspruch 1, wobei die Musterdruckschicht (405) unter Verwendung eines von wenigstens einem Digital-Punkt-Druck- (DDP) und Lasertransfer-Verfahren gebildet wird.

7. Verfahren nach Anspruch 1, wobei die zweite transparente Schicht (407) durch Sprühen transparenter Urethanfarbe gebildet wird.

8. Verfahren nach Anspruch 7, wobei die vorbestimmte Dicke der zweiten transparenten Schicht (407) in einem Bereich von 10-30 µm liegt.

9. Verfahren nach Anspruch 1, wobei die zweite Farbschicht (409) als eine Beschichtung aus Urethanfarbe auf Soft-Feel-Basis (SF-Basis) gebildet ist, wobei die Farbe auf SF-Basis eine Urethanfarbe mit der Textur und dem Aussehen von Leder ist.

10. Verfahren nach Anspruch 1, wobei der Gehäuserahmen, unter Verwendung von wenigstens einem Vorgang von Pressen bzw. Gießen, aus Metall gebildet ist.

11. Verfahren nach Anspruch 10, wobei der Gehäuserahmen wenigstens ein von Folgenden, nämlich Edelstahl, Aluminium, Magnesium und Kupfer umfasst.

12. Verfahren nach Anspruch 1, wobei der Gehäuserahmen für ein Gehäuse angewendet wird, das für ein tragbares Endgerät verwendet wird, das ein elektronisches Gerät ist.

13. Verfahren nach Anspruch 1, wobei das relevante in der Textur simulierte Material wenigstens eins aus Holz und Gummi umfasst.

14. Verfahren nach Anspruch 1, wobei der Gehäuserahmen für ein elektronisches Gerät hergestellt wird, wobei das elektronische Gerät, für das der Gehäuserahmen hergestellt wird, ein mobiles Endgerät umfasst und ein Fenster für einen Touch-Screen umfasst.

15. Elektronisches Gerät mit einem Gehäuse, wobei das Gehäuse umfasst:
Einen Gehäuserahmen (110, 120), der gebildet ist, eine taktile Textur in einer Form zu haben, die dem elektronischen Gerät entspricht;
eine erste transparente Schicht (401), die auf einer Oberfläche des Gehäuserahmens (110, 120) auf eine vorbestimmte Dicke ausgebildet ist;
eine erste Farbschicht (403), die auf einer Oberfläche des Gehäuserahmens (110, 120) gebildet ist und eine Farbe aufweist, die einem relevanten zu simulierenden Material entspricht;
eine Musterdruckschicht (405), die auf einem oberen Abschnitt der ersten Farbschicht (403) gebildet ist und einem visuellen Texturmuster entspricht, das eine visuelle Textur des relevanten Materials simuliert;
eine zweite transparente Schicht (407), die auf einem oberen Abschnitt der ersten Farbschicht (403) und der Musterdruckschicht (405) auf eine vorbestimmten Dicke gebildet ist;
eine zweite Farbschicht (409), die auf einem oberen Abschnitt der zweiten transparenten Schicht (407) gebildet ist; und
wobei die zweite Farbschicht (409) derart ausgebildet ist, dass die Farbe der ersten Farbschicht (403) und des visuellen Texturmusters der Musterdruckschicht (405) äußerlich sichtbar sind, dabei wird dem Benutzer eine visuelle und taktile Textur des simulierten Materials bereitgestellt, die einer visuellen und taktilen Textur des relevanten Materials entspricht.

## Revendications

1. Procédé de fabrication d'une coque (110, 120), le procédé comprenant :
la formation d'une coque (110, 120) d'une texture tactile dans une forme correspondant à un produit appliqué ;
la formation d'une première couche transparente (401) en enduisant une surface de la coque formée (110, 120) jusqu'à une épaisseur prédéterminée ;
la formation d'une première couche de peinture (403) sur une surface de la coque enduite (110, 120) ayant une couleur correspondant à un matériau pertinent à simuler ;
la formation d'une couche d'impression de motif (405) sur une partie supérieure de la première couche de peinture (403) correspondant à un motif de texture visuelle qui simule une texture visuelle du matériau pertinent ;
la formation d'une seconde couche transparente (407) en enduisant une partie supérieure de la première couche de peinture (403) et la couche d'impression de motif (405) jusqu'à une épaisseur prédéterminée ;
la formation d'une seconde couche de peinture (409) sur une partie supérieure enduite de la première couche de peinture (403) et la couche d'impression de motif (405) ; et
la formation de la seconde couche de peinture (409) de telle sorte que la couleur de la première couche de peinture (403) et le motif de texture visuelle de la couche d'impression de motif (405) soient extérieurement visibles, conférant ainsi à l'utilisateur une texture visuelle et tactile du matériau simulé qui correspond à une texture visuelle et tactile du matériau pertinent.

2. Procédé selon la revendication 1, dans lequel la formation de la coque comprend l'injection d'une préforme formée d'une résine synthétique pour donner une forme au moyen d'un moule,
dans lequel une surface d'injection du moule est traitée de telle sorte que le matériau simulé corresponde au motif de texture tactile du matériau pertinent et la surface d'injection est formée par au moins un cycle d'un processus de gravure utilisant un film prédéterminé sur lequel le motif de texture tactile du matériau simulé est formé.

3. Procédé selon la revendication 1, dans lequel la première couche transparente (401) est formée en pulvérisant une peinture d'uréthane transparente sur la coque (110, 120).

4. Procédé selon la revendication 3, dans lequel l'épaisseur prédéterminée de la première couche transparente (401) est comprise dans une plage de 10 à 20 µm.

5. Procédé selon la revendication 1, dans lequel une épaisseur totale de la première couche de peinture (403) et de la couche d'impression de motif (401) est formée dans une plage de 20 à 50 µm.

6. Procédé selon la revendication 1, dans lequel the couche d'impression de motif (405) est formée en utilisant au moins l'un d'un procédé d'impression numérique par points, DDP, et d'un procédé de transfert laser.

7. Procédé selon la revendication 1, dans lequel la seconde couche transparente (407) est formée en pulvérisant de la peinture d'uréthane transparente.

8. Procédé selon la revendication 7, dans lequel l'épaisseur prédéterminée de la seconde couche transparente (407) est comprise dans une plage de 10 à 30 µm.

9. Procédé selon la revendication 1, dans lequel la seconde couche de peinture (409) est formée sous forme d'enduction de peinture d'uréthane de type soyeux Soft Feel (SF), ladite peinture SF étant une peinture d'uréthane ayant la texture et l'aspect du cuir.

10. Procédé selon la revendication 1, dans lequel la coque est formée de métal par au moins l'une d'une opération de pression et d'une opération de coulée sous pression.

11. Procédé selon la revendication 10, dans lequel la coque comprend au moins l'un d'inox, d'aluminium, de magnésium et de cuivre.

12. Procédé selon la revendication 1, dans lequel la coque est appliquée pour un logement employé pour un terminal portable qui est un dispositif électronique.

13. Procédé selon la revendication 1, dans lequel le matériau pertinent de texture simulée comprend au moins l'un du bois et du caoutchouc.

14. Procédé selon la revendication 1, dans lequel la coque est fabriquée pour un dispositif électronique, le dispositif électronique pour lequel la coque est fabriqué comprenant un terminal mobile et comprenant une fenêtre pour un écran tactile.

15. Dispositif électronique ayant un logement, le logement comprenant :
une coque (110, 120) formée pour avoir une texture tactile dans une forme correspondant au dispositif électronique ; une première couche transparente (401) formée sur une surface de la coque (110, 120) jusqu'à une épaisseur prédéterminée ;
une première couche de peinture (403) formée sur une surface de la coque (110, 120) et ayant une couleur correspondant à un matériau pertinent à simuler ;
une couche d'impression de motif (405) formée sur une partie supérieure de la première couche de peinture (403) et correspondant à un motif de texture visuelle qui simule une texture visuelle du matériau pertinent ;
une seconde couche transparente (407) formée sur une partie supérieure de la première couche de peinture (403) et la couche d'impression de motif (405) jusqu'à une épaisseur prédéterminée ;
et une seconde couche de peinture (409) formée sur une partie supérieure de la seconde couche transparente (407) ; et
dans lequel la seconde couche de peinture (409) est formée de telle sorte que la couleur de la première couche de peinture (403) et le motif de texture visuelle de la couche d'impression de motif (405) soient extérieurement visibles, conférant ainsi à l'utilisateur une texture visuelle et tactile du matériau simulé qui correspond à une texture visuelle et tactile du matériau pertinent.
